(19) Europäisches Patentamt
European Patent Office
Office européen des brevets

(11) **EP 4 152 421 A1**

(12) **EUROPEAN PATENT APPLICATION**
published in accordance with Art. 153(4) EPC

(43) Date of publication:
**22.03.2023 Bulletin 2023/12**

(21) Application number: **20935286.3**

(22) Date of filing: **15.05.2020**

(51) International Patent Classification (IPC):
**H01L 35/34** (2006.01)

(52) Cooperative Patent Classification (CPC):
**H10N 10/01**

(86) International application number:
**PCT/KR2020/006404**

(87) International publication number:
**WO 2021/230406 (18.11.2021 Gazette 2021/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **LG Electronics, Inc.**
**Yeongdeungpo-gu**
**Seoul 07336 (KR)**

(72) Inventors:
• **LIM, Jongrae**
**Seoul 06772 (KR)**
• **SON, Jeonghun**
**Seoul 06772 (KR)**
• **JANG, Youngil**
**Seoul 06772 (KR)**
• **PARK, Jooyoung**
**Seoul 06772 (KR)**
• **KIM, Jun**
**Seoul 06772 (KR)**

(74) Representative: **Katérle, Axel**
**Wuesthoff & Wuesthoff**
**Patentanwälte PartG mbB**
**Schweigerstraße 2**
**81541 München (DE)**

(54) **EXTRUSION NOZZLE APPARATUS AND METHOD FOR EXTRUDING THERMOELECTRIC MATERIAL USING EXTRUSION NOZZLE APPARATUS**

(57) The present disclosure relates to an extrusion nozzle apparatus and a method for extruding a thermoelectric material using the extrusion nozzle apparatus. An extrusion nozzle apparatus according to one embodiment of the present disclosure comprises: an inlet introducing material; an outlet discharging the input material; and a discharge pipe formed in a multi-stage shape including a plurality of stages, wherein the input material is pressurized inside the discharge pipe and moves in a first direction from the inlet toward the outlet. The cross-sectional area of the plurality of stages in a direction perpendicular to the first direction progressively decreases from the inlet to the outlet. Accordingly, the thermoelectric performance of a thermoelectric material may be improved, and production cost and production time may be reduced.

FIG. 2

**Description**

<u>BACKGROUND</u>

**1. Field of the disclosure**

The present disclosure relates to an extrusion nozzle apparatus and a method for extruding a thermoelectric material using the extrusion nozzle apparatus and, more particularly, to an extrusion nozzle apparatus having a multi-stage shape that is decreased in cross-sectional area from an inlet to an outlet and a method for extruding a thermoelectric material using the extrusion nozzle apparatus.

**2. Description of the Related Art**

Recently, a thermoelectric material is attracting attention with the use of energy harvesting technology, which collects energy wasted or consumed in daily life and then recycles the energy as electric power.

The thermoelectric material refers to a material using thermoelectric effect. The thermoelectric effect is a phenomenon generated by the movement of electrons and holes inside the material, and the thermoelectric effect refers to a reversible and direct energy conversion between heat and electricity.

A thermoelement may be applied to a thermoelectric power generation field using an electromotive force generated from a temperature difference between both ends of the thermoelectric material, and may be applied to a thermoelectric cooling and heating field using a temperature difference between both ends of the material caused by electricity supply. In general, the thermoelement has a structure in which a P-type thermoelectric material and an N-type thermoelectric material are joined between metal electrodes to form a PN junction pair.

The thermoelement may be classified into an element using a temperature change of electric resistance, an element using Seebeck effect, an element using Peltier effect, etc.

In this connection, the Seebeck effect is the phenomenon in which the temperature difference is directly converted into electricity, and the Peltier effect is the phenomenon in which heat is released at an upper junction and is absorbed at a lower junction when an electric current flows through the junction of dissimilar materials. The Seebeck effect and the Peltier effect are distinguished from Joule heating in that they are thermodynamically reversible.

Using the Seebeck effect, waste heat may be used as an energy source. Therefore, it can be used in various fields such as engines and exhausters of vehicles and medical devices using human body heat. Further, using the Peltier effect, the thermoelectric material may be used for a vibration-free and low-noise refrigerator, an air conditioner, and various micro cooling systems that do not use refrigerant gas, and may also be used for a cooling system of semiconductor equipment.

On the other hand, such a thermoelectric material may improve the performance of a material by increasing electric conductivity when the crystal orientation of grains is increased. As a method of controlling a crystal structure of the thermoelectric material, research on hot deformation such as hot pressing is being conducted.

As the hot deformation is performed several times, the grains of the thermoelectric material are aligned in a certain direction and Hall mobility increases.

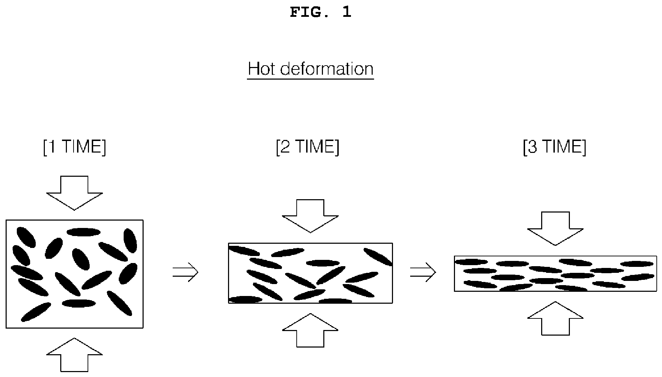

FIG. 1 shows that grains of a thermoelectric material are aligned in a certain direction according to the number of applications of hot deformation processes.

Referring to the drawing, as the number of times of the hot deformation increases from one to three times, the tendency for grains to be oriented in one direction increases. In this case, the electric conductivity is increased, thus enhancing the performance of the thermoelectric material.

However, as the number of times of the hot deformation increases, the steps of the process required to manufacture the thermoelectric material are increased, the size of a press zig is increased, and the unit cost of a material is increased due to an increase in tact time of the process.

<u>SUMMARY</u>

Accordingly, the present disclosure has been made keeping in mind the above problems occurring in the related art, and an objective of the present disclosure is to provide an extrusion nozzle apparatus including a multi-stage shape that is decreased in cross-sectional area from an inlet to an outlet, thus obtaining the effect of a plurality of hot deformations by only one extrusion, and a method for extruding a thermoelectric material using the extrusion nozzle apparatus.

Further, another objective of the present disclosure is to provide an extrusion nozzle apparatus including a multi-stage shape that is decreased in cross-sectional area from an inlet to an outlet, thus reducing the tact time of a production process and lowering the production cost of a material, and a method for extruding a thermoelectric material using the extrusion nozzle apparatus.

Further, a further objective of the present disclosure is to provide an extrusion nozzle apparatus for performing a heating operation so that temperature is lowered from a stage of an inlet side to a stage of an outlet side, thus enhancing the performance of a thermoelectric material, and a method for extruding a thermoelectric material using the extrusion nozzle apparatus.

The objectives of the present disclosure are not limited to the above-mentioned objectives, and other objectives which are not mentioned will be clearly understood by those skilled in the art from the following description.

In order to accomplish the above objectives, the present disclosure provides an extrusion nozzle apparatus including an inlet introducing material, an outlet discharging the input material, and a discharge pipe formed in a multi-stage shape including a plurality of stages, wherein the input material is pressurized inside the discharge pipe and moves in a first direction from the inlet toward the outlet, and a cross-sectional area of the plurality of stages in a direction perpendicular to the first direction progressively decreases from the inlet to the outlet.

The plurality of stages included in the discharge pipe may include interfaces, and an angle between the interface of each of the stages and the first direction may be greater than 0° and is less than or equal to 90°.

The plurality of stages may include first to N-th stages (N is a natural number of 2 or more), which are sequentially positioned from the inlet side to the outlet side. When angles between the interfaces of the first to N-th stages and the first direction are denoted as R1 to RN, the following conditional expression may be satisfied.

$$R1 \geq R2 \geq R3 \geq ... \geq RN$$

The plurality of stages included in the discharge pipe may include inner surfaces, and the inner surface of each of the stages may be formed to be parallel to the first direction.

The plurality of stages may include the first to N-th stages (N is a natural number of 2 or more), which are sequentially positioned from the inlet side to the outlet side. When lengths of the inner surfaces of the first to N-th stages are denoted as L1 to LN, the following conditional expression may be satisfied.

$$L1 \leq L2 \leq L3 \leq ... \leq LN$$

A cross-sectional area of the outlet may be smaller than a cross-sectional area of the inlet.

A cross-section of the outlet may have a shape of a circle, an ellipse, a polygon, or an angle.

A cross-section of each of the plurality of stages perpendicular to the first direction may have a shape of a circle, an ellipse, a polygon, or an angle.

The extrusion nozzle apparatus may further include a heating portion heating each of the stages of the discharge pipe.

The heating portion may heat each of the stages for a temperature of each of the stages of the discharge pipe being kept constant.

The plurality of stages may include the first to N-th stages (N is a natural number of 2 or more), which are sequentially positioned from the inlet side to the outlet side. When temperatures of the first to N-th stages are denoted as T1 to TN, the heating portion may heat each of the stages for the following conditional expression being satisfied.

$$T1 \geq T2 \geq T3 \geq ... \geq TN$$

The extrusion nozzle apparatus may further include a plurality of temperature sensors included in the stages of the discharge pipe, respectively, and positioned to be adjacent to the inner surfaces of the respective stages, and the heating portion may heat each of the stages, based on the temperature of each of the stages measured by the plurality of temperature sensors.

The heating portion may include a heating device individually formed for each of the stages for individually heating the temperature of each of the stages of the discharge pipe.

The heating device may include a heating block formed along an outer surface of each of the stages of the discharge pipe.

The extrusion nozzle apparatus may further include a flange part formed on an outer surface of the discharge pipe in which the inlet is positioned, and including a plurality of holes, and an extruder body may be detachably attached through the flange part.

Further, in order to accomplish the above objectives, the present disclosure provides a method for extruding a thermoelectric material using an extrusion nozzle apparatus, the method including introducing the thermoelectric material into an inlet, pressurizing a piston in a direction from the inlet to an outlet and moving the input material in a discharge pipe including a plurality of stages whose cross-sectional areas are progressively decreased from the inlet to the outlet, and extruding the input material to the outlet.

The pressurizing may include heating each of the stages for temperatures of the plurality of stages included in the discharge pipe being progressively decreased from a stage positioned on the inlet side to a stage positioned on the outlet side.

Details of other embodiments are included in the detailed description and drawings.

## EFFECTS OF THE DISCLOSURE

According to the present disclosure, the following effects are obtained.

An extrusion nozzle apparatus and a method for extruding a thermoelectric material using the extrusion nozzle apparatus according to an embodiment of the present disclosure are advantageous in that the apparatus includes a multi-stage shape that is decreased in cross-sectional area from an inlet to an outlet, thus obtaining the effect of a plurality of hot deformations by only one extrusion,.

Further, an extrusion nozzle apparatus and a method for extruding a thermoelectric material using the extrusion nozzle apparatus according to an embodiment of the present disclosure are advantageous in that the apparatus includes a multi-stage shape that is decreased in cross-sectional area from an inlet to an outlet, thus reducing the tact time of a production process and lowering the production cost of a material.

Further, an extrusion nozzle apparatus and a method for extruding a thermoelectric material using the extrusion nozzle apparatus according to an embodiment of the present disclosure are advantageous in that the apparatus performs a heating operation so that temperature is lowered from a stage of an inlet side to a stage of an outlet side, thus enhancing the performance of a thermoelectric material.

Effects of the present disclosure are not limited to the above-mentioned effects, and other effects which are not mentioned will be clearly understood by those skilled in the art from the following description.

## BRIEF DESCRIPTION OF THE DRAWINGS

FIG. 1 shows that grains of a thermoelectric material are aligned in a certain direction according to the number of applications of hot deformation processes;

FIG. 2 is a sectional view of an extrusion nozzle apparatus according to an embodiment of the present disclosure when seen in one direction;

FIG. 3 is a sectional view of the extrusion nozzle apparatus of FIG. 2 when seen in another direction;

FIG. 4 is a diagram for explaining the angles of the inner surface and interface of the extrusion nozzle apparatus of FIG. 2;

FIG. 5 is a diagram for explaining the pressure applied to a material extruded from the extrusion nozzle apparatus according to an embodiment of the present disclosure;

FIG. 6 is a diagram for explaining the length of the inner surface of the extrusion nozzle apparatus of FIG. 2;

FIG. 7 is a sectional view of an extrusion nozzle apparatus according to another embodiment of the present disclosure when seen in one direction;

FIG. 8 is a flowchart showing a method for manufacturing a thermoelectric material according to an embodiment of the present disclosure;

FIG. 9 is a flowchart showing detailed steps of a sintering process in the manufacturing method of FIG. 8;

FIG. 10 is a diagram for explaining a crystal direction of a thermoelectric material extruded from the extrusion nozzle apparatus according to an embodiment of the present disclosure; and

FIG. 11 is a diagram for explaining the cutting process and cutting shape of the thermoelectric material extruded from the extrusion nozzle apparatus according to the present disclosure.

## DETAILED DESCRIPTION OF THE PREFERRED EMBODIMENTS

Hereinafter, the present disclosure will be described in detail with reference to the accompanying drawings.

The same reference numerals are used throughout the drawings to designate the same or similar components, and a duplicated description thereof will be omitted herein. Further, the terms "module", "unit"', etc. described in this specification are given or used together for the ease of description, but do not have a distinct meaning or function. Thus, the terms "module" and "unit" may be used interchangeably.

When it is determined that the detailed description of the known art related to the present disclosure may be obscure the gist of the invention, the detailed description thereof will be omitted. Further, it is to be understood that the accompanying drawings are merely for making those skilled in the art easily understand embodiments disclosed herein, and the present disclosure is intended to cover not only embodiments disclosed herein, but also various alternatives, equivalents, or substitutes that fall within the spirit and scope of the present disclosure.

Although the terms "first", "second", etc. may be used herein to describe various elements, these elements should not be limited by these terms. These terms are only used to distinguish one element from another element.

It will be understood that when an element is referred to as being "coupled" or "connected" to another element, it can be directly coupled or connected to the other element or intervening elements may be present therebetween. In contrast, it should be understood that when an element is referred to as being "directly coupled" or "directly connected" to another element, there are no intervening elements present.

Herein, the singular forms are intended to include the plural forms as well, unless the context clearly indicates otherwise.

It will be further understood that the terms "comprise", "include", "have", etc. when used in this specification, specify the presence of stated features, integers, steps, operations, elements, components, and/or combinations thereof but do not preclude the presence or addition of one or more other features, integers, steps, operations, elements, components, and/or combinations thereof.

The present disclosure is directed to an extrusion nozzle apparatus and a method for extruding a thermoelectric material using the extrusion nozzle apparatus, which can enhance the performance of the thermoelectric material.

The performance of the thermoelectric material may be evaluated using dimensionless figure-of-merit ZT defined by the following Equation 1.

$$[\text{Equation 1}]$$

$$ZT = \frac{S^2 \sigma T}{k}$$

In Equation 1, ZT represents the dimensionless figure-of-merit of the thermoelectric material, S represents a Seebeck coefficient, $\sigma$ represents an electric conductivity, T represents absolute temperature, and k represents thermal conductivity. Here, $S^2\sigma$ is defined as a power factor.

It is determined that the larger the dimensionless figure-of-merit, the better the performance of the thermoelectric material. In order to increase the dimensionless figure-of-merit ZT, a material that is large in Seebeck coefficient S and electric conductivity $\sigma$, i.e. power factor, and is low in thermal conductivity k is required.

However, the Seebeck coefficient and the electric conductivity are generally in a trade-off relationship. For a high Seebeck coefficient, electrons should have a heavy effective mass. In contrast, for a high electric conductivity, electrons should have a light effective mass. For example, the metal with high electric conductivity has a low Seebeck coefficient, while an insulating material with high electric conductivity has a high Seebeck coefficient. Therefore, due to this trade-off relationship, it is difficult to improve the thermoelectric performance of the thermoelectric material.

In the thermoelectric material, the larger the degeneracy of an energy band, the larger the Seebeck coefficient. Further, the larger the dispersion of the energy band, the larger the electric conductivity. However, since the thermoelectric material usually has larger energy band degeneracy as the energy band dispersion is reduced, it is difficult to improve the thermoelectric performance.

Generally, the smaller a particle size, the smaller the thermal conductivity, and the smaller the number of grains through which current passes, the larger the electric conductivity. Therefore, the dimensionless figure-of-merit of the thermoelectric material may be improved by controlling the growth of crystals.

On the other hand, hot pressing is used as one of crystal structure control techniques.

In the manufacturing process of the thermoelectric material, a solidified thermoelectric material is pulverized, and consolidated by hot pressing or the like to form a sintered body. However, when consolidation is performed by the hot pressing, the grain tends to solidify in a crystal orientation direction to be oriented in a direction perpendicular to the pressure direction.

The extrusion nozzle apparatus for manufacturing the thermoelectric material according to an embodiment of the present disclosure proposes a structure which can increase the performance of the thermoelectric material and reduce the number of processes through the multi-stage shape.

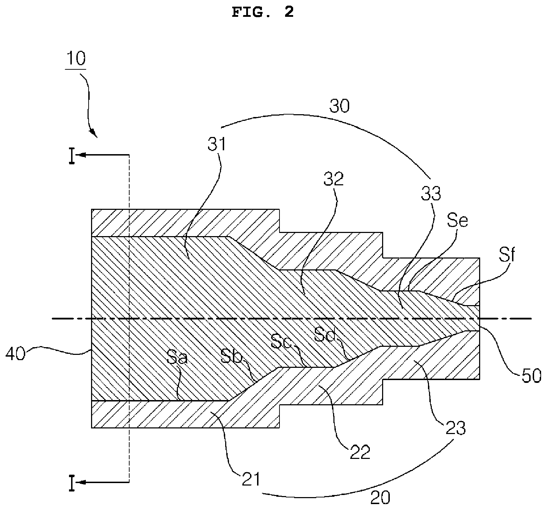

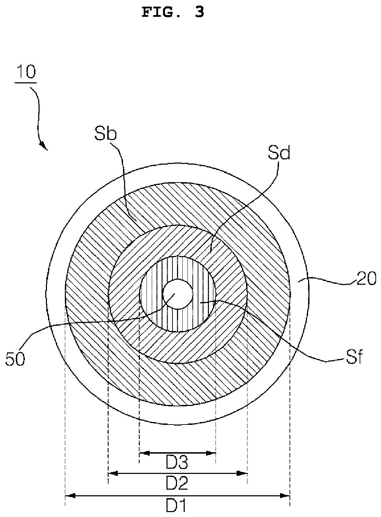

FIG. 2 is a sectional view of the extrusion nozzle apparatus according to an embodiment of the present disclosure when seen in one direction, and FIG. 3 is a sectional view of the extrusion nozzle apparatus of FIG. 2 when seen in another direction.

In the manufacturing process of the thermoelectric material, an extrusion-sintering method may be used. The extrusion-sintering method is a method of manufacturing the thermoelectric material by pressurizing the thermoelectric material to pass through a nozzle. In order to extrude and sinter the thermoelectric material, the extrusion nozzle apparatus may be used.

Referring to FIG. 2, the extrusion nozzle apparatus 10 according to an embodiment of the present disclosure may include a discharge pipe 30, an inlet 40, and an outlet 50.

The discharge pipe 30 defines a body of the extrusion nozzle apparatus. The discharge pipe 30 may be formed of a metal material, and may be in the form of a hollow pipe extending long in a direction.

The inlet 40 may be formed on one side of the discharge pipe 30 to have a cross-section perpendicular to a longitudinal direction (hereinafter referred to as a "first direction") of the discharge pipe 30. The material may be put through the inlet 40 into the extrusion nozzle apparatus 10.

The outlet 50 may be formed on the other side of the discharge pipe 30 to have a cross-section perpendicular to the first direction. The material that is put through the inlet 40 into the extrusion nozzle apparatus 10 may be discharged through the outlet 50. On the other hand, the cross-sectional area perpendicular to the first direction of the outlet 50 may be smaller than the cross-sectional area of the inlet 40.

The cross-section of the outlet 50 may have the shape of a circle, an ellipse, a polygon, or an angle. Here, the term "angle shape" means a figure that is bent on one side thereof. For example, the angle shape may be an "'L" shape or "'U" shape, but is not limited thereto.

Spaces 31, 32, and 33 of the discharge pipe 30 in which the material moves may be formed in a multi-stage shape including a plurality of stages in the first direction from the inlet 40 to the outlet 50. In the drawing, the discharge pipe 30 is formed to have three stages, i.e., a first stage 31, a second stage 32, and a third stage 33, for example. However, the number of stages included in the discharge pipe 30 is not limited thereto, but two or more stages, i.e., various numbers of stages may be formed.

The cross-sectional areas of the respective stages perpendicular to the first direction may be different from each other. To be more specific, the cross-sectional areas of the stages may be equal to each other or be decreased from the stage positioned around the inlet 40 to the stage positioned around the outlet 50.

FIG. 3 is a sectional view taken along line I-I of FIG. 2. In the example of the drawing, it is assumed that the cross-section is circular. However, the cross-section of each stage perpendicular to the longitudinal direction may have various shapes, such as an elliptical shape, a polygonal shape, and an angle shape, without being limited thereto.

Referring to the drawing, the cross-sectional area of the second stage 32 may be equal to or smaller than the cross-sectional area of the first stage 31, and the cross-sectional area of the third stage 33 may be equal to or smaller than the cross-sectional area of the second stage 32.

Thus, the material introduced into the inlet 40 may be pressurized in phases by a piston (not shown) and the discharge pipe 30 while moving in the discharge pipe 30 in the first direction, and then be discharged through the outlet 50.

On the other hand, the extrusion nozzle apparatus 10 may be formed to be detachably attached to an extruder (not shown) that extrudes the thermoelement. The extrusion nozzle apparatus 10 may include a flange part (not shown) formed on an outer surface of an end of the discharge pipe 30 in which the inlet 40 is positioned and includes a plurality of holes. The flange part of the extrusion nozzle apparatus 10 may be bolted to a flange part formed on a side of the extruder through a plurality of holes. For example, the flange part of the extrusion nozzle apparatus 10 may be attached to the flange part provided on a side of a container of the extruder via a bolt.

On the other hand, a support means (not shown) may be formed on a lower end of the extrusion nozzle apparatus 10 to be bolted to a predetermined portion of the extruder, thus enabling firm coupling. The bolt fastening direction of the support means may be perpendicular to the bolt fastening direction of the flange part. This structure allows the extrusion nozzle apparatus 10 to be firmly coupled to the extruder, and allows a hot extrusion process to be stably performed in the extrusion nozzle apparatus 10.

On the other hand, the extrusion nozzle apparatus 10 may be formed of hot tool steel such as STD61, but may be formed of various kinds of materials having excellent high-temperature strength and wear resistance without being limited thereto.

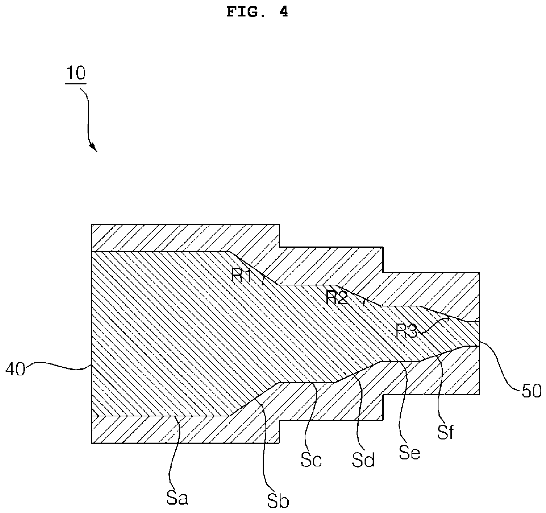

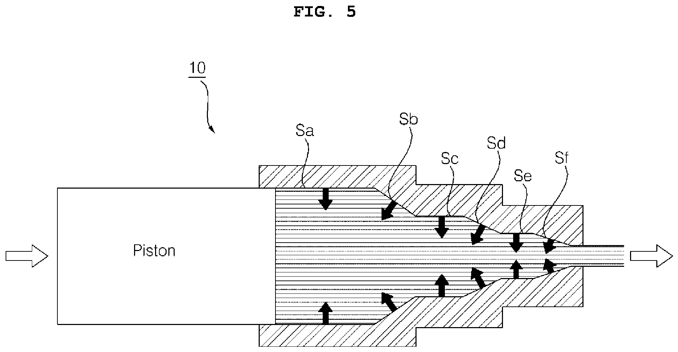

FIG. 4 is a diagram for explaining the angles of the inner surface and interface of the extrusion nozzle apparatus 10 of FIG. 2, and FIG. 5 is a diagram for explaining the pressure applied to a material extruded from the extrusion nozzle apparatus 10 of FIG. 2.

Referring to FIGS. 4 and 5, each stage of the discharge pipe 30 of the extrusion nozzle apparatus 10 may include the inner surface and the interface.

For example, the first stage 31 may include a first inner surface Sa and a first interface Sb, the second stage 32 may include a second inner surface Sc and a second interface Sd, and the third stage 33 may include a third inner surface Se and a third interface Sf.

In the plurality of stages included in the discharge pipe 30, each inner surface may be formed to be parallel to the first direction. For example, the first inner surface Sa to third inner surface Sf may be formed to be parallel to the first direction. The material introduced into the discharge pipe 30 may be pressurized by the inner surface and the interface while passing through each stage. Therefore, depending on the direction in which the inner surface and the interface are formed, the direction in which grains in the introduced material are aligned may be changed. When the inner surface is formed to be parallel to the first direction in which the introduced material moves, the grains in the introduced material may be aligned to be parallel to the first direction.

However, the first inner surface Sa to third inner surface Sf may not be parallel to the first direction, and may be formed to have the angle of 45° or less with respect to the first direction. In this case, the grains in the introduced material may be aligned to be oriented in the first direction.

On the other hand, in the plurality of stages included in the discharge pipe 30, the angle between each interface and the first direction may be more than 0° and be less than or equal to 90°. For example, the angles R1, R2, and R3 between the first interface to third interface Se and the first direction may be more than 0° and be less than or equal to 90°. Therefore, as the material introduced into the discharge pipe 30 moves in a direction from the inlet 40 to the outlet 50, the material may smoothly move to a next stage at the interface of each of the stages having different cross-sectional areas.

Referring to FIG. 5, the introduced material may be pressurized by force acting in a diagonal direction from the interface. Depending on the direction in which the interface is formed, the direction in which the grains in the introduced material are aligned may be changed. However, the interface may be a surface formed to allow the introduced material to smoothly move to a next stage at the interface of each of the stages having different cross-sectional areas. Therefore, the alignment direction of the grains extruded from the extrusion nozzle apparatus 10 may be mainly determined by the direction of the inner surface.

On the other hand, in order to determine the grain alignment direction by the inner surface direction, the length of the inner surface of each stage may be longer than that of the interface. For example, the length of the first inner surface Sa may be longer than that of the first interface Sb, the length of the second inner surface Sc may be longer than that of the second interface Sd, and the length of the third inner surface Se may be longer than that of the third interface Sf.

On the other hand, in the plurality of stages included in the discharge pipe 30, the angle between each interface and the first direction may be kept constant or decreased from the stage positioned around the inlet 40 to the stage positioned around the outlet 50. Specifically, the plurality of stages may include first to N-th stages (N is a natural number of 2 or more) that are sequentially positioned from the inlet 40 to the outlet 50. When the angles between the interfaces of the first to N-th stages and the first direction are denoted as R1 to RN, the following conditional expression may be satisfied.

$$R1 \geq R2 \geq R3 \geq ... \geq RN.$$

In the example shown in the drawing, the conditional expression of R1 ≥ R2 ≥ R3 may be satisfied.

As described above, the interface may be formed to allow the introduced material to smoothly move to a next stage at the interface of each of the stages having different cross-sectional areas. If the angle between the material moving direction and the interface is decreased toward the stage having a smaller cross-sectional area and positioned around the outlet 50, the introduced material may smoothly move to a next stage. However, the angle between each interface and the first direction is not limited thereto, and various angles are possible.

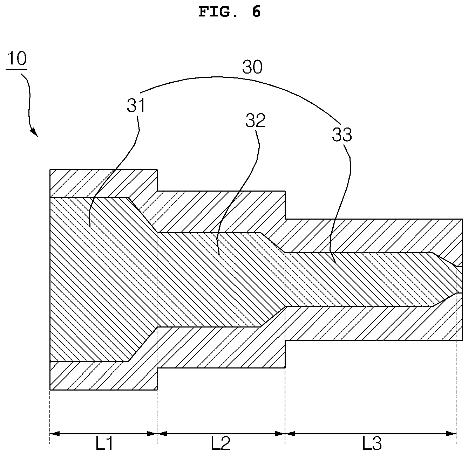

FIG. 6 is a diagram for explaining the length of the inner surface of the extrusion nozzle apparatus 10 of FIG. 2.

In the plurality of stages included in the discharge pipe 30, the length of each stage in the first direction may be kept constant or increased from the stage positioned around the inlet 40 to the stage positioned around the outlet 50. Specifically, the plurality of stages may include the first to N-th stages (N is a natural number of 2 or more), which are sequentially positioned from the inlet 40 to the outlet 50. When the lengths of the first to N-th stages in the first direction are denoted as L1 to LN, the following conditional expression may be satisfied.

$$L1 \leq L2 \leq L3 \leq ... \leq LN$$

In the example shown in the drawing, the conditional expression of L1 ≤ L2 ≤ L3 may be satisfied.

As described above, the cross-sectional areas of the respective stages may be decreased from the first stage to the N-th stage. In this case, speed at which the material moves in the first direction in a corresponding stage may be gradually increased toward the stage having a smaller cross-sectional area and positioned around the outlet 50. Therefore, the length of the corresponding stage in the first direction is formed to be increased toward the stage having the smaller cross-sectional area and positioned around the outlet 50, thus minimizing the shortening of the residence time of the introduced material inside the stage positioned around the outlet 50.

Further, as the cross-sectional area of a last stage of the discharge pipe 30 is narrow and time for which material introduced at the last stage moves is longer, the grain alignment direction in the introduced material may be evenly formed to be parallel to the first direction. Therefore, the length of each of the stages of the discharge pipe 30 may be formed to be long, thus improving the orientation of grains.

On the other hand, in the plurality of stages included in the discharge pipe 30, the length of each stage in the first direction may vary depending on the residence time of the introduced material inside each stage.

In the multi-stage extrusion nozzle apparatus 10, the introduced material may move in each stage by the piston that moves from the inlet 40 to the outlet 50. Since the cross-sectional areas of the respective stages are different from each other, the residence time of the introduced material in each stage becomes shorter as the cross-sectional area of the corresponding stage is reduced. Therefore, when it is necessary to increase the residence time of the introduced material in a specific stage, it is possible to adjust the residence time in the corresponding stage by extending the length of the corresponding stage in the first direction.

However, the length of each stage in the first direction is not limited thereto, and the stage may be formed in various lengths.

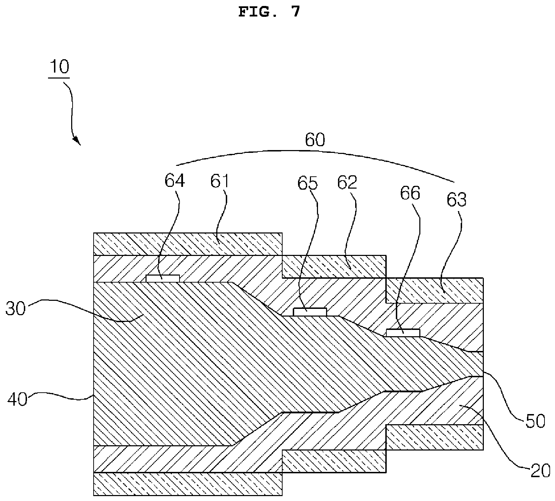

FIG. 7 is a sectional view of an extrusion nozzle apparatus 10 according to another embodiment of the present disclosure when seen in one direction.

Referring to the drawing, the extrusion nozzle apparatus 10 according to another embodiment of the present disclosure may include a discharge pipe 30, an inlet 40, and an outlet 50, and may further include a heating portion 60.

The heating portion 60 may heat each stage of the discharge pipe 30. In order to heat each stage, the heating portion 60 may be formed to surround the outer surface of the discharge pipe 30. The heating portion 60 may be formed to contact the outer surface of the discharge pipe 30, and may be formed to be spaced apart from the outer surface by a predetermined distance. On the other hand, the heating portion 60 may be integrally formed in the discharge pipe 30.

The heating portion 60 may heat each of the stages 31, 32, and 33 to keep the temperature of each of the stages 31, 32, and 33 of the discharge pipe 30 constant. To this end, the extrusion nozzle apparatus 10 may include a plurality of temperature sensors 64, 65, and 66 that are included in the stages 31, 32, and 33, respectively, and are positioned to be adjacent to the inner surfaces Sa, Sc, and Se of the stages.

Further, the heating portion 60 may include a temperature controller (not shown). The temperature controller may control the temperature of the heating portion 60 that heats each stage.

On the other hand, the temperature controller may be configured as a device separate from the heating portion 60, and may be connected to the heating portion 60 to control the operation of the heating portion 60.

The temperature controller may control the heating portion 60 that heats each of the stages 31, 32, and 33 to keep temperature constant, based on the temperature of each of the stages 31, 32, and 33 measured by the plurality of temperature sensors 64, 65, and 66. One of the plurality of temperature sensors 64, 65, and 66 may be formed per each stage, and the plurality of temperature sensors may be formed to be spaced apart from each other.

On the other hand, the heating portion 60 may individually heat each of the stages 31, 32, and 33 of the discharge pipe 30. To this end, the heating portion 60 may include a plurality of heating devices 61, 62, and 63 that are individually formed for the respective stages 31, 32, and 33.

The plurality of heating devices 61, 62, and 63 may be formed to be spaced apart from each other while surrounding the outer surfaces of the stages 31, 32, and 33 of the discharge pipe 30. The plurality of heating devices 61, 62, and 63 may be formed to contact the outer surface of the discharge pipe 30 and be formed to be spaced apart from the outer surface by a predetermined distance. On the other hand, the plurality of heating devices 61, 62, and 63 may be integrally formed in the discharge pipe 30.

The plurality of heating devices 61, 62, and 63 may be formed of a material having high thermal conductivity such as copper or alloy (e.g. brass) containing copper.

Each of the plurality of heating devices 61, 62, and 63 may be a heating block formed along the outer surface of each of the stages 31, 32, and 33 of the discharge pipe 30.

The heating block may include a heating coil (not shown) therein. The heating coil may be spirally formed in the heating block and be arranged to surround the entire outer surface of the stage of the discharge pipe 30. The heating coil may be formed of a material having high thermal conductivity such as copper or alloy containing copper, and may be a coil in the shape of a pipe through which a heating medium such as water or oil may pass. By heating the heating coil or passing a heating medium into the heating coil, the heating block may heat each of the stages 31, 32, and 33 of the discharge pipe 30.

On the other hand, the heating block may be formed to contact and be detachably attached to the outer surface of the discharge pipe 30. Since the configuration of the heating block corresponds to a general configuration in the related art, a detailed description thereof will be omitted.

On the other hand, the heating portion 60 may heat each of the stages 31, 32, and 33 of the discharge pipe 30 so that their temperatures are the same as each other, and may individually heat each of the stages 31, 32, and 33 so that their temperatures are different from each other. For example, the heating portion 60 may heat each stage so that the temperatures of the stages are reduced from the stage around the inlet 40 to the stage around the outlet 50.

The plurality of stages may include the first to N-th stages (N is a natural number of 2 or more), which are sequentially positioned from the inlet 40 to the outlet 50. When temperatures of the first to N-th stages are denoted as T1 to TN, the following conditional expression may be satisfied.

$$T1 \geq T2 \geq T3 \geq \ldots \geq TN$$

In the example of the drawing, the conditional expression of $T1 \geq T2 \geq T3$ may be satisfied.

Table 1

| Case | | 1 | 2 | 3 | 4 | 5 |
|---|---|---|---|---|---|---|
| Tempera ture- | 1 stage | T2 | T2 | T3 | T3 | T3 |
| | 2 stage | T3 | T2 | T2 | T3 | T2 |
| Profile | 3 stage | T2 | T3 | T2 | T3 | T1 |
| Electric conductivity | | 46% | 53% | 103% | 100% | 121% |
| Thermal conductivity | | 100% | 1080 | 110% | 100% | 82% |
| Material ZT | | 69% | 72% | 99% | 100% | 112% |

Table 1 shows the comparison of the electric conductivity, thermal conductivity, and ZT of the thermoelectric material according to the temperature condition change applied to each stage in the extrusion nozzle apparatus including three stages.

In Table 1, a second temperature T2 is higher than a first temperature T1, and a third temperature T3 is higher than the second temperature T2. The temperature profile represents the temperature condition applied to each stage. The electric conductivity, thermal conductivity, and ZT are expressed as the percentage (%) of the relative magnitudes of the remaining cases, based on the fourth case of Table 1.

Referring to Table 1, case 5 in which the temperatures of the corresponding stages decrease from the first stage 31 to the third stage 33 represents the highest dimensionless figure-of-merit ZT of the thermoelectric material. Comparing case 4 in which the temperatures of the stages are the same as each other with case 5 in which the temperatures of the corresponding stages decrease from the first stage to the third stage, it can be seen that the thermal conductivity of the thermoelectric material is reduced, but the electric conductivity is significantly increased, and consequently the dimensionless figure-of-merit ZT is increased, in case 5.

On the other hand, when comparing cases 1 and 2 with case 4, it can be seen that the electric conductivity of the thermoelectric material is significantly reduced, and consequently the dimensionless figure-of-merit ZT is significantly reduced, when the temperatures of the stages are increased from the first stage 31 to the second stage 32 or from the second stage 32 to the third stage 33.

As such, even if the structure of the discharge pipe 30 formed so that the cross-sectional areas of the stages are reduced from the stage around the inlet 40 to the stage around the outlet 50 is used, the electric conductivity of the thermoelectric material may vary depending on the temperature setting of each stage. This is because the size of fine grains may be increased due to sintering as the hot extrusion process proceeds.

As in case 5, by controlling the heating portion 60 so that the temperatures of the corresponding stages decrease from the first stage to the third stage, a phenomenon in which the size of the grains increases is suppressed, so that the dimensionless figure-of-merit ZT of the thermoelectric material can be increased.

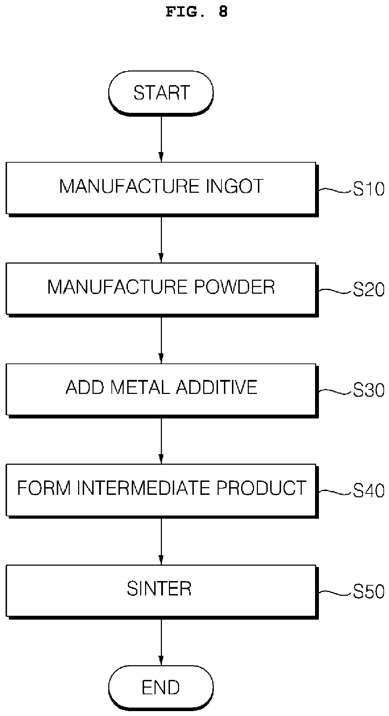

FIG. 8 is a flowchart showing a method for manufacturing a thermoelectric material according to an embodiment of the present disclosure.

In order to manufacture the thermoelectric material, a bulk thermoelectric material (ingot) is manufactured using a raw material for the thermoelectric material (S10). Here, the raw material of the thermoelectric material may include Cu, I, Bi, Sb, and Te.

Specifically, at step S10, after the raw material is weighed in a molar ratio according to the composition of the thermoelectric material, it is charged into a quartz tube and vacuum sealed. Subsequently, after the material is charged into a melting furnace to be melted at about 1,000°C, the material may be cooled to room temperature to manufacture the ingot.

The manufactured bulk thermoelectric material (ingot) is pulverized to be manufactured in the form of powder (S20). For example, the ingot may be made in the form of powder through a ball milling process.

A certain amount of metal additive is added to the bulk thermoelectric material manufactured in the form of powder (S30). The metal additive may be any one or more materials selected from the raw material for the thermoelectric material. Further, the metal additive may be a material having a melting point that is lower than that of the ingot.

The metal additive may be a material that may form a potential D inside a lattice or at an interface when forming an intermediate product. For example, if the melting point is low enough to melt before forming a solid crystal, the potential D may not be formed inside the lattice or at the interface.

The metal additive may be included in an amount of > 20 to 25 wt% compared to the raw material. Further, the metal additive may be tellurium (Te).

The intermediate product is formed using a melting and rapid cooling device in a state in which the metal additive is mixed with the bulk thermoelectric material manufactured in the form of powder (S40). The intermediate product may be a ribbon-shaped material. The intermediate product may be formed in a form in which the metal additive is dispersed in the thermoelectric material.

In the rapid cooling process, the material is charged into the quartz tube having a narrow nozzle size, melted by induction heating, and then instantaneously discharged to a copper rotating plate that rotates at high speed by applying gas pressure, thus performing cooling and consolidation and thereby making a ribbon-shaped particle.

The step of forming the intermediate product may include a step of charging the thermoelectric material powder and the metal additive into the tube having the nozzle, a step of melting the thermoelectric material powder and the metal additive in a liquid state, and a step of discharging the melted material to the rotating plate to form the ribbon-shaped particle.

Thereafter, the formed intermediate product is sintered to manufacture the thermoelectric material (S50). At this time, the sintering temperature may be formed at a temperature higher than the melting point of the metal additive.

When sintering the intermediate product, the extrusion-sintering method may be applied. The ribbon-shaped material is made of a bulk-shaped thermoelectric material using the extrusion-sintering. Here, the extrusion-sintering method may be performed using the multi-stage-shaped extrusion nozzle apparatus 10 according to an embodiment of the present disclosure.

Subsequently, the bulk-shaped thermoelectric material is cut and processed into a desired shape to observe thermoelectric characteristics (Seebeck coefficient, electric conductivity, and thermal conductivity) and microstructures.

Hereinafter, the method for manufacturing the thermoelectric material according to an embodiment of the present disclosure will be described in detail.

1. Manufacture of ingot

According to $(CuI)_x(Bi_2Se_{2.7}Te_{0.3})_{1-x}$, x=0.003 composition ratio, Cu, I, Bi, Sb, and Te are quantitatively measured in a molar ratio, and then charged into the quartz tube.

At this time, vacuum sealing is performed at the vacuum level of 10-5 torr.

In this way, the vacuum-sealed quartz tube is put into an electric furnace, the temperature is gradually raised up to 1,050°C and is maintained at 1,050°C for 12 hours. Thereafter, cooling is performed, so that the ingot is manufactured.

2. Manufacture of bulk thermoelectric material

The ingot material made of $(CuI)_x(Bi_2Se_{2.7}Te_{0.3})_{1-x}$, x=0.003 material compositions is manufactured into powder having the size of several to tens of microns through a milling process.

Subsequently, in order to form nanoparticles (e.g., $Cu_2Te$), 20 to 25 wt% of tellurium (Te) and 1 to 5 wt% copper (Cu) powder as the metal additives are mixed with matrix composition powder, and then the intermediate product is formed using the rapid cooling device.

That is, in order to make a ribbon using the rapid cooling device, it is made in the form of a pellet having the diameter of 10 to 15mm and the height of 10mm or more, and then is put into the quartz tube having the nozzle size of about 0.3 to 0.4mm in diameter.

Subsequently, after powder is melted by induction heating, it is discharged to the copper rotating plate having the diameter of 300mm, which is rotated at high speed by applying pressure, so that it is cooled and consolidated, thus obtaining a ribbon-shaped intermediate product in which the metal additive is precipitated. That is, the metal additive may be distributed in the form of nanoparticles.

At this time, when the rotating plate rotates at 2800 to 3200 rpm, a ribbon-shaped material having a thickness of about 1 $\mu$m to 100 $\mu$m is obtained. Such a ribbon-shaped material may be obtained in a dispersed form by forming metal additive nanoparticles in the thermoelectric material, and the size of the thermoelectric material and the metal additive may be formed in a range of several tens of nm to several hundreds of nm due to the effect of rapid cooling.

For example, the ribbon-shaped material may be made using the rapid cooling device while including $(CuI)_x(Bi_2Se_{2.7}Te_{0.3})_{1-x}$ material as the thermoelectric matrix and Cu/Te as the metal additive.

Subsequently, after pulverizing the ribbon-shaped intermediate product manufactured through the rapid cooling and solidification method using the rapid cooling device, pressing and sintering is performed through the extrusion-sintering method using the multi-stage shaped extrusion nozzle apparatus 10 of the present disclosure.

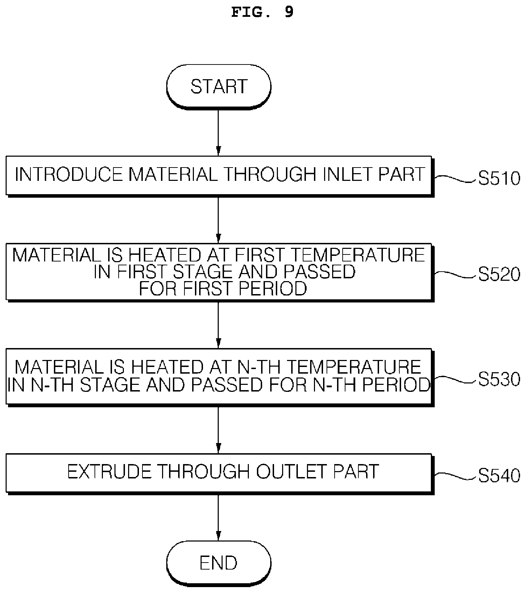

FIG. 9 is a flowchart showing detailed steps of a sintering process S50 in the manufacturing method of FIG. 8, and FIGS. 10 and 11 are diagrams for explaining the crystal orientation direction of a thermoelectric material formed by the extrusion and sintering method and an element using direction according to a cutting shape.

Hereinafter, the extrusion method of the thermoelectric material according to an embodiment of the present disclosure will be described in detail with reference to FIG. 9 to 11.

Referring to FIG. 9, in a step of manufacturing the thermoelectric material by sintering the formed intermediate product, extrusion-sintering may be applied.

The thermoelectric material (intermediate product) is introduced into the extruder. Specifically, the thermoelectric material is introduced into the inlet 40 of the multi-stage-shaped extrusion nozzle apparatus 10 according to an embodiment of the present disclosure (S510).

The piston is pressurized in a direction from the inlet 40 to the outlet 50 so that the input material moves in the discharge pipe 30 including the plurality of stages whose cross-sectional areas are progressively decreased from the inlet 40 to the outlet 50 (S520).

Subsequently, the input material is extruded to the outlet by the movement of the piston (S530).

The input material may be heated at a predetermined temperature for a predetermined time in the extrusion process to manufacture the thermoelectric material. Specifically, the material may be heated at a predetermined temperature for a predetermined time inside each stage of the multi-stage-shaped extrusion nozzle apparatus 10. Time for which the input material stays in each stage may be controlled by the cross-sectional area of each stage, the length of each stage, and the moving speed of the piston. On the other hand, in order to control the time when the input material stays in each stage, the piston may be controlled to move in the first direction and then remain stationary for a predetermined time.

The ratio of the inlet 40 and the outlet 50 may be determined so that the extrusion ratio is at least 5 for the uniformity and refinement of the thermoelectric material particle. For example, the extrusion ratio may be set to 5:1, 10:1, 20:1, 30:1, etc., but is not limited thereto.

The pressure may have 5 to 20 MPa, and the temperature of the discharge pipe 30 may be heated to 300°C to 600°C. The piston may move in the discharge pipe 30 so that several seconds to several tens of minutes have elapsed until the material introduced into the inlet 40 is discharged to the outlet 50. However, these extrusion environmental conditions are not limited thereto, and may be changed according to the characteristics of the thermoelectric material and the structure of the extrusion nozzle apparatus 10.

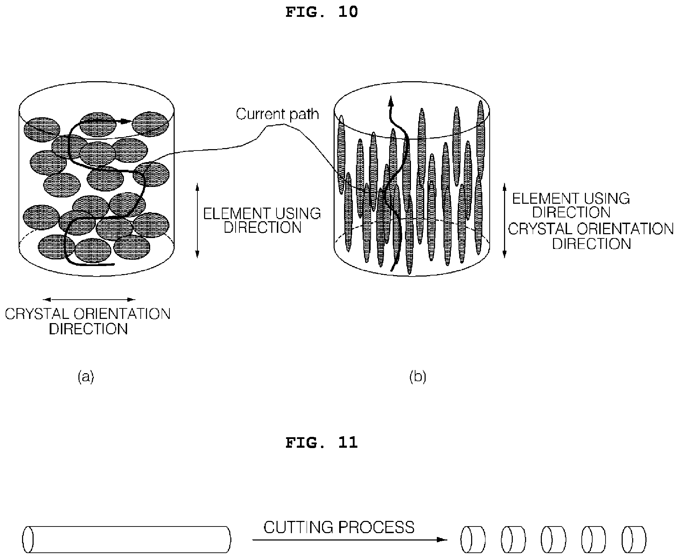

FIG. 10 shows the comparison of the crystal orientation directions of the thermoelectric materials manufactured by a conventional discharge plasma sintering method and the extrusion-sintering method of the present disclosure.

The discharge plasma sintering method is a method in which a material is charged into a carbon mold, and current is applied while the material is pressurized, thus generating spark type plasma between powder particles forming the material and thereby performing sintering. If current is applied, the material is instantaneously heated and the powder particles are connected to each other, so that sintering is performed.

The orientation direction of grains formed by the conventional discharge plasma sintering method is different from the element using direction. Therefore, the length of current pass may increase in the thermoelectric material, and thereby the electric conductivity of the thermoelectric material may decrease.

In contrast, the grain orientation direction of the thermoelectric material manufactured by the extrusion-sintering method of the present disclosure is the same as the element using direction. As shown in FIG. 10, in the thermoelectric material extruded and sintered in the multi-stage-shaped extrusion nozzle apparatus 10, the grains may be oriented to be parallel to the first direction, and the grain orientation direction may be the same as the material using direction after the thermoelectric material is cut.

Referring to FIG. 11, in the extrusion nozzle apparatus 10 of the present disclosure, the extruded and sintered thermoelectric material may be cut in the extruded longitudinal direction. In this case, a portion wasted when cutting the sintered material may be minimized, and the grain orientation direction may be the same as the material using direction after cutting the thermoelectric material.

Further, the conventional discharge plasma sintering method is problematic in that there is a limit in uniformly dispersing nanoparticles in a matrix compound as the sintering area increases. However, the extrusion-sintering method is advantageous in that it is performed by a small-area continuous process, so that nanoparticles can be relatively uniformly dispersed in the matrix compound.

On the other hand, the extrusion-sintering method using the multi-stage-shaped extrusion nozzle apparatus 10 of the present disclosure can enhance the orientation of grains, as if hot deformation was performed multiple times only by one extrusion.

Table 2

| Sample | HP | HD1 | HD2 | HD3 |
|---|---|---|---|---|
| Electric conductivity | 100% | 1160 | 128% | 133% |
| Thermal conductivity | 100% | 108% | 113% | 116% |
| Material ZT | 100% | 107% | 128% | 133% |

Table 2 shows the result of comparing a case where the thermoelectric material is sintered using hot pressing and a case where hot extrusion sintering is performed using single-stage, two-stage, and three-stage type extrusion nozzle apparatuses (extrusion nozzle apparatus of the present disclosure).

In Table 2, HP represents the results using the hot pressing, and HD1 to HD3 represent the results using the single-stage, two-stage, and three-stage type extrusion nozzle apparatuses. In this Table, the electric conductivity, the thermal conductivity, and ZT indicate the relative magnitude of the remaining results in percentage (%), based on the results of HP.

Referring to Table 2, compared to the sintering case HP using hot pressing, in the hot extrusion sintering case HD1, the electric conductivity, the thermal conductivity, and the dimensionless figure-of-merit ZT of the thermoelectric material increase. Further, as the number of stages included in the extrusion nozzle apparatus used for the hot extrusion sintering increases, the electric conductivity, the thermal conductivity, and the dimensionless figure-of-merit ZT of the thermoelectric material increase.

As such, by hot extrusion-sintering the material using the multi-stage-shaped extrusion nozzle apparatus 10 of the present disclosure, the orientation of grains may be improved as if hot deformation was performed multiple times only by one extrusion, and the electric conductivity of the thermoelectric material is increased, thus improving the dimensionless figure-of-merit ZT.

Thus, the number of hot deformations is reduced, so that it is possible to reduce the tact time of a production process and consequently lower the production cost of the thermoelectric material.

On the other hand, in step S520, each of the stages may be heated so that the temperatures of the plurality of stages included in the discharge pipe 30 are decreased from the stage positioned around the inlet 40 to the stage positioned around the outlet 50. As previously described in relation to Table 1, each stage is heated so that the temperature of each stage decreases, thus suppressing a phenomenon in which the size of grains increases, and thereby increasing the dimensionless figure-of-merit ZT of the thermoelectric material.

Although the present disclosure was described with reference to specific embodiments shown in the drawings, it is apparent to those skilled in the art that the present disclosure may be changed and modified in various ways without departing from the scope of the present disclosure, which is described in the following claims.

**Claims**

1. An extrusion nozzle apparatus comprising:

   an inlet introducing material;
   an outlet discharging the input material; and
   a discharge pipe formed in a multi-stage shape including a plurality of stages, wherein the input material is pressurized inside the discharge pipe and moves in a first direction from the inlet toward the outlet,
   wherein a cross-sectional area of the plurality of stages in a direction perpendicular to the first direction progressively decreases from the inlet to the outlet.

2. The extrusion nozzle apparatus of claim 1, wherein the plurality of stages included in the discharge pipe comprises interfaces, and
   an angle between the interface of each of the stages and the first direction is greater than 0° and is less than or equal to 90°.

3. The extrusion nozzle apparatus of claim 2, wherein the plurality of stages comprises first to N-th stages (N is a natural number of 2 or more), which are sequentially positioned from the inlet side to the outlet side, and
   when angles between the interfaces of the first to N-th stages and the first direction are denoted as $R_1$ to $R_N$, the following conditional expression is satisfied.

$$R_1 \geq R_2 \geq R_3 \geq \ldots \geq R_N$$

4. The extrusion nozzle apparatus of claim 1, wherein the plurality of stages included in the discharge pipe comprises inner surfaces, and
the inner surface of each of the stages is formed to be parallel to the first direction.

5. The extrusion nozzle apparatus of claim 1, wherein the plurality of stages comprises the first to N-th stages (N is a natural number of 2 or more), which are sequentially positioned from the inlet side to the outlet side, and
when lengths of the inner surfaces of the first to N-th stages are denoted as $L_1$ to $L_N$, the following conditional expression is satisfied.

$$L_1 \leq L_2 \leq L_3 \leq \ldots \leq L_N$$

6. The extrusion nozzle apparatus of claim 1, wherein a cross-sectional area of the outlet is smaller than a cross-sectional area of the inlet.

7. The extrusion nozzle apparatus of claim 1, wherein a cross-section of the outlet has a shape of a circle, an ellipse, a polygon, or an angle.

8. The extrusion nozzle apparatus of claim 1, wherein a cross-section of each of the plurality of stages perpendicular to the first direction has a shape of a circle, an ellipse, a polygon, or an angle.

9. The extrusion nozzle apparatus of claim 1, further comprising:
a heating portion heating each of the stages of the discharge pipe.

10. The extrusion nozzle apparatus of claim 9, wherein the heating portion heats each of the stages for a temperature of each of the stages of the discharge pipe being kept constant.

11. The extrusion nozzle apparatus of claim 9, wherein the plurality of stages comprises the first to N-th stages (N is a natural number of 2 or more), which are sequentially positioned from the inlet side to the outlet side, and
when temperatures of the first to N-th stages are denoted as $T_1$ to $T_N$, the heating portion heats each of the stages for the following conditional expression being satisfied.

$$T_1 \geq T_2 \geq T_3 \geq \ldots \geq T_N$$

12. The extrusion nozzle apparatus of claim 9, further comprising:

a plurality of temperature sensors included in the stages of the discharge pipe, respectively, and positioned to be adjacent to the inner surfaces of the respective stages,
wherein the heating portion heats each of the stages, based on the temperature of each of the stages measured by the plurality of temperature sensors.

13. The extrusion nozzle apparatus of claim 9, wherein the heating portion comprises a heating device individually formed for each of the stages for individually heating the temperature of each of the stages of the discharge pipe.

14. The extrusion nozzle apparatus of claim 13, wherein the heating device comprises a heating block formed along an outer surface of each of the stages of the discharge pipe.

15. The extrusion nozzle apparatus of claim 1, further comprising:

a flange part formed on an outer surface of the discharge pipe in which the inlet is positioned, and including a plurality of holes,
wherein an extruder body is detachably attached through the flange part.

16. A method for extruding a thermoelectric material using an extrusion nozzle apparatus, the method comprising:

introducing the thermoelectric material into an inlet;

pressurizing a piston in a direction from the inlet to an outlet and moving the input material in a discharge pipe including a plurality of stages whose cross-sectional areas are progressively decreased from the inlet to the outlet; and

extruding the input material to the outlet.

17. The method of claim 16, wherein the pressurizing comprises:

heating each of the stages for temperatures of the plurality of stages included in the discharge pipe being progressively decreased from a stage positioned on the inlet side to a stage positioned on the outlet side.

FIG. 1

Hot deformation

[1 TIME]　　　　　　　　　[2 TIME]　　　　　　　　　[3 TIME]

FIG. 2

FIG. 3

FIG. 4

FIG. 5

FIG. 6

FIG. 7

FIG. 8

```
        ┌─────────────┐
        │    START    │
        └──────┬──────┘
               │
               ▼
   ┌───────────────────────┐
   │  MANUFACTURE INGOT    │─── S10
   └───────────┬───────────┘
               │
               ▼
   ┌───────────────────────┐
   │  MANUFACTURE POWDER   │─── S20
   └───────────┬───────────┘
               │
               ▼
   ┌───────────────────────┐
   │   ADD METAL ADDITIVE  │─── S30
   └───────────┬───────────┘
               │
               ▼
   ┌───────────────────────┐
   │ FORM INTERMEDIATE PRODUCT │─── S40
   └───────────┬───────────┘
               │
               ▼
   ┌───────────────────────┐
   │        SINTER         │─── S50
   └───────────┬───────────┘
               │
               ▼
        ┌─────────────┐
        │     END     │
        └─────────────┘
```

FIG. 9

```
        ┌─────────────┐
        │    START    │
        └──────┬──────┘
               │
               ▼
   ┌───────────────────────────────────┐
   │ INTRODUCE MATERIAL THROUGH INLET PART │──S510
   └───────────────────┬───────────────┘
                       │
                       ▼
   ┌───────────────────────────────────┐
   │ MATERIAL IS HEATED AT FIRST TEMPERATURE │
   │      IN FIRST STAGE AND PASSED          │──S520
   │           FOR FIRST PERIOD              │
   └───────────────────┬───────────────┘
                       │
                       ▼
   ┌───────────────────────────────────┐
   │ MATERIAL IS HEATED AT N-TH TEMPERATURE │
   │ IN N-TH STAGE AND PASSED FOR N-TH PERIOD │──S530
   └───────────────────┬───────────────┘
                       │
                       ▼
   ┌───────────────────────────────────┐
   │    EXTRUDE THROUGH OUTLET PART     │──S540
   └───────────────────┬───────────────┘
                       │
                       ▼
        ┌─────────────┐
        │     END     │
        └─────────────┘
```

FIG. 10

Current path

ELEMENT USING
DIRECTION

CRYSTAL ORIENTATION
DIRECTION

(a)

ELEMENT USING
DIRECTION
CRYSTAL ORIENTATION
DIRECTION

(b)

FIG. 11

CUTTING PROCESS

## INTERNATIONAL SEARCH REPORT

| International application No. |
|---|
| **PCT/KR2020/006404** |

**A. CLASSIFICATION OF SUBJECT MATTER**

**H01L 35/34**(2006.01)i

According to International Patent Classification (IPC) or to both national classification and IPC

**B. FIELDS SEARCHED**

Minimum documentation searched (classification system followed by classification symbols)

H01L 35/34(2006.01); B21C 23/00(2006.01); B21C 23/08(2006.01); B21C 23/14(2006.01); B21C 25/02(2006.01); B21J 5/06(2006.01); B29C 45/20(2006.01); B29C 45/74(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 열전(thermoelectric), 노즐(nozzle), 직경(diameter), 다단(multilevel), 온도 (temperature)

**C. DOCUMENTS CONSIDERED TO BE RELEVANT**

| Category* | Citation of document, with indication, where appropriate, of the relevant passages | Relevant to claim No. |
|---|---|---|
| Y | JP 2002-248517 A (KOMATSU LTD.) 03 September 2002 (2002-09-03)<br>　　See paragraphs [0026]-[0030]; claims 1 and 6; and figure 2. | 1-17 |
| Y | JP 2007-130661 A (DAIDO STEEL CO., LTD.) 31 May 2007 (2007-05-31)<br>　　See paragraphs [0022]-[0031]; claims 1-3; and figures 1 and 3. | 1-17 |
| Y | JP 10-315289 A (RICOH CO., LTD.) 02 December 1998 (1998-12-02)<br>　　See paragraphs [0028]-[0033]; and figure 1. | 9-14,17 |
| A | JP 2005-000993 A (MIZUNUMA, Susumu) 06 January 2005 (2005-01-06)<br>　　See paragraphs [0015]-[0096]; and figures 1-8. | 1-17 |
| A | JP 10-272654 A (JAPAN STEEL WORKS LTD.) 13 October 1998 (1998-10-13)<br>　　See claims 1-3; and figure 1. | 1-17 |

☐ Further documents are listed in the continuation of Box C.　　☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **22 January 2021** | **26 January 2021** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**
Information on patent family members

International application No.

**PCT/KR2020/006404**

| Patent document cited in search report | | | Publication date (day/month/year) | Patent family member(s) | | | Publication date (day/month/year) |
|---|---|---|---|---|---|---|---|
| JP | 2002-248517 | A | 03 September 2002 | JP | 3942873 | B2 | 11 July 2007 |
| JP | 2007-130661 | A | 31 May 2007 | None | | | |
| JP | 10-315289 | A | 02 December 1998 | JP | 3542060 | B2 | 14 July 2004 |
| JP | 2005-000993 | A | 06 January 2005 | JP | 2005-000990 | A | 06 January 2005 |
| | | | | JP | 2005-000991 | A | 06 January 2005 |
| | | | | JP | 2005-000992 | A | 06 January 2005 |
| | | | | JP | 2005-000994 | A | 06 January 2005 |
| | | | | JP | 2005-000996 | A | 06 January 2005 |
| | | | | JP | 4305151 | B2 | 29 July 2009 |
| | | | | JP | 4305163 | B2 | 29 July 2009 |
| | | | | JP | 4487282 | B2 | 23 June 2010 |
| JP | 10-272654 | A | 13 October 1998 | JP | 3351703 | B2 | 03 December 2002 |

Form PCT/ISA/210 (patent family annex) (July 2019)